# EUROPÄISCHE PATENTSCHRIFT

(11) **EP 3 906 124 B1**
(45) Veröffentlichungstag und Bekanntmachung des Hinweises auf die Patenterteilung: **29.06.2022**
(21) Anmeldenummer: 20706938.6
(22) Anmeldetag: 13.02.2020
(51) Int. Cl.: B21C 23/06, B21C 23/18, B21K 23/00, H01L 21/48, H01L 23/367, H01L 23/373, H01L 23/473, H05K 7/20

(54) **VERFAHREN ZUR HERSTELLUNG EINER KÜHLPLATTE**
METHOD FOR PRODUCING A COOLING PLATE
PROCÉDÉ DE FABRICATION D'UNE PLAQUE DE REFROIDISSEMENT

(30) Priorität: 26.02.2019 DE 102019001383
(43) Veröffentlichungstag der Anmeldung: 10.11.2021
(73) Patentinhaber: Holzhauer GmbH&Co. KG, 72517 Sigmaringendorf (DE)
(72) Erfinder: HOLZHAUER, Anton, 72517 Sigmaringendorf (DE); HOLZHAUER, Joachim, 72517 Sigmaringendorf (DE)
(74) Vertreter: Hering, Hartmut
(86) Internationale Anmeldenummer: PCT/EP2020/000043
(87) Internationale Veröffentlichungsnummer: WO 2020/173599

(56) Entgegenhaltungen:
- EP-A1- 3 117 953
- WO-A1-2017/208669
- WO-A1-2019/007547
- JP-A- 2012 227 365

## Beschreibung

Die Erfindung bezieht sich auf Verfahren zur Herstellung einer Kühlplatte aus Material mit sehr guter Wärmeleitfähigkeit, wie Kupfer, Aluminium, deren Legierung oder dergleichen mit etwa senkrecht über eine Grundfläche vorstehenden Pins auf einer vom Kühlmittel überstrichenen Wirkfläche, wobei die Pins von einem im wesentlichen radial verlaufenden, ebenen Umfangsrand umgeben sind, wobei die Kühlplatte in einem Werkzeug mittels Umformen eines Werkstücks hergestellt wird.

Derartige Kühlplatten kommen beispielsweise zur Anwendung bei Batteriekonstruktionen, Inverter, Brennstoffzellen, wärmeempfindlichen elektrischen oder elektronischen Bauelementen, wie Chips oder dergleichen.

Üblicherweise werden Kühlplatten der gattungsgemäßen Art mittels Schmieden oder spanabhebender Bearbeitung hergestellt, wobei meistens zusätzlich aufwändige Nachbearbeitungen erforderlich sind. Bisher sind derartige Kühlplatten in der Herstelllung relativ teuer und meist fällt auch Abfall bei der Bearbeitung des Materials mit sehr guter Wärmeleitfähigkeit an, welches in den Gestehungskosten relativ teuer ist.

Aus DE 10 2015 120 835 A1 ist ein Herstellungsverfahren für Kühlplatten bekannt, bei dem ein Flachmaterial mittels Walzen bearbeitet wird. Hierbei ergeben sich unregelmäßig ausgeformte Pins, welche ausreichend beabstandet sein müssen, um weitgehend gleichlange Pins zu erstellen. Ferner sind aufwändige, insbesondere zeitaufwändige Nachbearbeitungen erforderlich. Daher erhält man eine kleinere Pindichte an der Wirkfläche und die Kühlwirkung ist vermindert.

EP 3 117 953 A1 beschreibt ein Verfahren zur Herstellung einer Kühlplatte aus Material mit sehr guter Wärmeleitfähigkeit, wie Kupfer, Aluminium, deren Legierung oder dgl. mit etwa senkrecht über eine Grundfläche vorstehenden Pins auf einer vom Kühlmittel überstrichenen Wirkfläche, wobei die Pins von einem im wesentlichen radial verlaufenden, ebenen, funktionsnotwendigen Umfangsrand umgeben sind, und die Kühlplatte in einem Werkzeug mittels Umformen eines Werkstücks hergestellt wird. Das Werkstück in Form eines Flachmaterialzuschnitts mit einheitlicher Materialdicke wird in das Werkzeug eingelegt, welches einen mit Pinausformöffnungen im Werkzeug zusammenarbeitenden Stempel zur Erzeugung der Pins umfasst, wobei mittels des Stempels durch Pressen die Pins im Zusammenwirken mit den Pinausformöffnungen des Werkzeugs ausgeformt werden.

Aus JP 2012 227 365 A ist ein Verfahren zur Herstellung einer Kühlplatte bekannt, bei dem kein Niederhalter im Außenumfangsbereich des Flachmaterials verwendet wird, weshalb das Material nicht am "Aufsteigen", also am Rückwärtsfließpressen entlang des Stempels gehindert wird, wodurch eben auch keine Fließbehinderung für das Material im Werkzeug gegeben ist.

Aus DE 10 2018 005 265 A1 , welche die Basis für den Oberbegriff des Anspruchs 1 bildet, ist ein Verfahren zur Herstellung einer Kühlplatte bekannt, bei dem ein zweigeteilter Stempel genutzt wird, wobei in einer ersten Stufe zunächst der Außenumfang des Flachmaterials mit einem Außenstempel gestaucht und gebreitet wird, während der Pinstempel als Niederhalter fungiert.

In der zweiten Stufe fungiert der Außenstempel als Niederhalter und der Pinstempel extrudiert die Pins an das Flachmaterial. Es sind hierbei nicht nur die beiden Umformstufen getauscht, sondern es kann vielmehr in beiden Umformstufen dasselbe Unterwerkzeug verwendet werden.

Die Erfindung zielt darauf ab und ihr liegt die Aufgabe zu Grund, ein Verfahren zur Herstellung einer Kühlplatte der gattungsgemäßen Art bereitzustellen, welches sich kostengünstig darstellen lässt sowie materialsparend und Resourcen-schonend ist und eine äußerst effektive Kühlwirkung mit großer Pindichte an der Wirkfläche hat.

Die Aufgabe wird gelöst mit einem Verfahren gemäß Anspruch 1.

Bei der Erfindung kommt somit ein kostengünstiges Kaltpressen oder Einpressen mit vorangehender Erwärmung zum Einsatz, wobei bei der Ausbildung der Pins auf der vom Kühlmittel überstrichenen Wirkfläche einerseits das Material des Flächenmaterialzuschnitts bzw. des Einlegeteils unmittelbar durch Umformen genutzt wird, sodass mit der erfindungsgemäßen Herstellung im wesentlichen kein Materialverlust oder Materialabfall anfällt, da es sich um eine materialsparende und Resourcen-schonende Herstellungsweise handelt. Bei einer ersten Stufe des Verfahrens werden mittels des Innenstempels (Pinstempels) im Zusammenwirken mit den Pinausformöffnungen im Werkzeug zuerst die Pins im Mittelbereich durch Pressen ausgeformt, wobei der Außenstempel den Flachmaterialzuschnitt niederhält. Hierbei entsteht eine Materialsenke im Bereich der ausgeformten Pins, und der dem Außenstempel zugeordnete Umfangsrand bleibt am Flachmaterialzuschnitt unverformt.

In einem zweiten Schritt, der gegebenenfalls in einem weiteren Werkzeug ausgeführt wird, wird dann der Umfangsmaterialüberstand bei mittels des Innenstempels des Werkzeugs niedergehaltenen Werkstück mit den ausgeformten Pins durch Pressen mittels des Außenstempels der Umfangsrand mit verminderter Materialdicke ausgeformt wird, so dass man einen im wesentlichen ebenen, funktionsnotwenigen Umfangsrand hierbei erhält, der im wesentlichen bündig in den Materialsenkenbereich nach der Ausformung der Pins übergeht. Hierbei ist von Vorteil, dass in beiden Schritten eine Art Selbstausrichtung des Flachmaterialzuschnitts oder des Einlegeteils im Werkzeug erfolgt. Im ersten Verfahrensschritt erfolgt die Ausrichtung durch das vollumfängliche Umschließen des Werkstückaufnahmeraumes des Werkzeugs bei eingelegtem Flachmaterialzuschnitt und im zweiten Verfahrensschritt erfolgt die Ausrichtung durch die ausgeformten Pins in den Pinausformungsöffnungen im Werkzeug, wenn mit Hilfe des Außenstempels der Umfangsrand niedergedrückt und ausgeformt wird.

Ein weiterer Vorteil könnte sich dadurch ergeben, dass die Presskräfte beim zweiten Verfahrensschritt wesentlich geringer als beim ersten Verfahrensschritt sind, so dass hierfür gegebenenfalls eine nicht so hochleistungsfähige Presse wie für die Ausformung der Pins eingesetzt werden kann. Hierdurch können jeweils auf die erforderlichen Presskräfte angepasste, abgestimmte Umformbearbeitungsmaschinen eingesetzt werden. Hierdurch können sich geringere Betriebskosten und Bearbeitungskosten ergeben.

Mittels einer Auswurfeinrichtung können wenigstens einige der dem Umfangsrand benachbarten Pinausformöffnungen des Werkzeugs vor und um eine Pinreihe versetzt beim Ausformen verschlossen werden.

Vorzugsweise werden beim erfindungsgemäßen Verfahren die Pins ausgehend von ihren freien Enden kalibriert. Beim Kalibrieren sind die freien Enden der Pins eben gepresst oder aufgestaucht. Ferner kann bei der Kalibrierung der Pins auch eine gegenkonische Ausbildung erzeugt werden, wenn ausgehend von den freien Enden der Pins eine solche Kalibrierung erfolgt, dass der Durchmesser der Pins ausgehend vom freien Ende in Richtung der Fußfläche kleiner wird.

Alternativ kann mittels der Kalibrierung auch eine konische Ausbildung vorgesehen werden, wenn ausgehend von den freien Enden der Pins eine solche Kalibrierung erfolgt, dass der Durchmesser der Pins ausgehend von den freien Enden in Richtung der Fußfläche größer wird.

Zweckmäßigerweise ist der Flachmaterialzuschnitt viereckförmig ausgebildet. Insbesondere kann es sich um einen rechteckförmigen Flachmaterialzuschnitt handeln.

Vorzugsweise wird der Flachmaterialzuschnitt von gewalztem oder gepresstem Material, insbesondere von gewalztem Kupfer gebildet.

Zusammenfassend ist es beim erfindungsgemäßen Verfahren wesentlich, dass die Kühlplatten mit den Pins ausschließlich durch Umformung hergestellt werden.

Weitere Einzelheiten, Merkmale und Vorteile der Erfindung ergeben sich aus der nachstehenden Beschreibung von bevorzugten Ausführungsbeispielen ohne beschränkenden Charakter unter Bezugnahme auf die beigefügte Zeichnung. Darin gilt:
- Fig. 1: eine schematische Schnittansicht eines Anwendungsbeispiels einer Kühlplatte nach der Erfindung;
- Fig. 2 bis 10: schematische perspektivische Teilschnittansichten zur Verdeutlichung des Verfahrensablaufs bei dem Herstellungsverfahren einer Kühlplatte nach der Erfindung;
- Fig. 11 und Fig. 12: sind Ausschnittsvergrößerungen einzelner Pins der in Fig. 10 gezeigten Kühlplatte, und
- Fig. 13 bis 15: schließlich zeigen schematisch als Beispiele weitere Ausgestaltungsformen der Pins.

In den Figuren der Zeichnung sind gleiche oder ähnliche Teile mit denselben Bezugszeichen versehen.

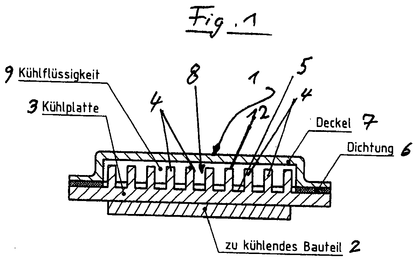

In Fig. 1 ist schematisch ein Anwendungsbeispiel für ein insgesamt mit 1 bezeichnete Kühlanordnung gezeigt. An einem zu kühlenden Bauteil 2, wie ein elektrisches oder elektronisches Bauteil, ist eine Kühlplatte 3 mit der den Pins gegenüberliegenden Fläche angebracht. Wie gezeigt, umfasst die Kühlplatte 3 Pins 4 auf einer vom Kühlmittel überstrichenen Wirkfläche 5. Mittels einer Dichtung 6 ist bei dem dargestellten Beispiel ein Deckel 7 fluiddicht mit dem im wesentlichen radial verlaufenden, ebenen Umfangsrand W, welcher die Pins 4 umgibt, derart verbunden, dass sich zwischen dem Deckel 7 und den Pins 4 der Kühlplatte 3 ein Zwischenraum 8 bildet, welcher von einem Kühlmittel 9, wie Kühlflüssigkeit oder Kühlfluid durchströmt wird.

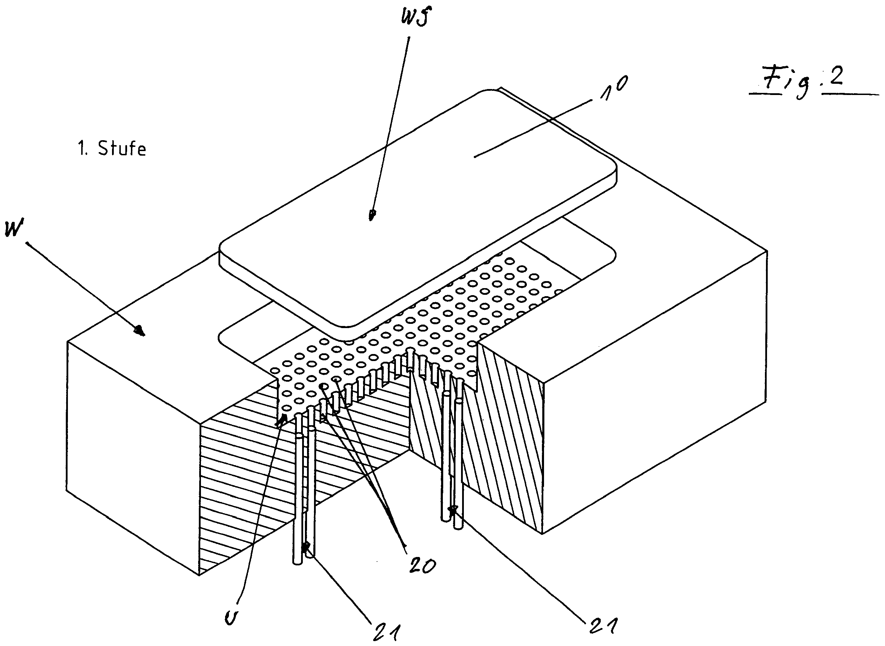

Anhand den Figuren 2 bis 10 wird der erfindungsgemäße Verfahrensablauf zur Herstellung einer Kühlplatte aus Material mit sehr guter Wärmeleitfähigkeit näher erläutert.

In Fig. 2 ist schematisch in Teilschnittdarstellung ein Werkzeug W dargestellt, welches am Boden viele Ausformöffnungen 20 hat. Mittels einer Auswurfeinrichtung 21 sind wenigstens einige der dem Umfangsrand U benachbarten Ausformöffnungen 20 verschlossen. Beabstandet zum Werkzeug W ist schematisch ein Werkstück WS in Form eines Flachmaterialzuschnitts als Rohteil 10 oder Einlegeteil angedeutet. Dieses Werkstück WS hat in der Fig. 2 eine einheitliche oder gleich große Materialdicke.

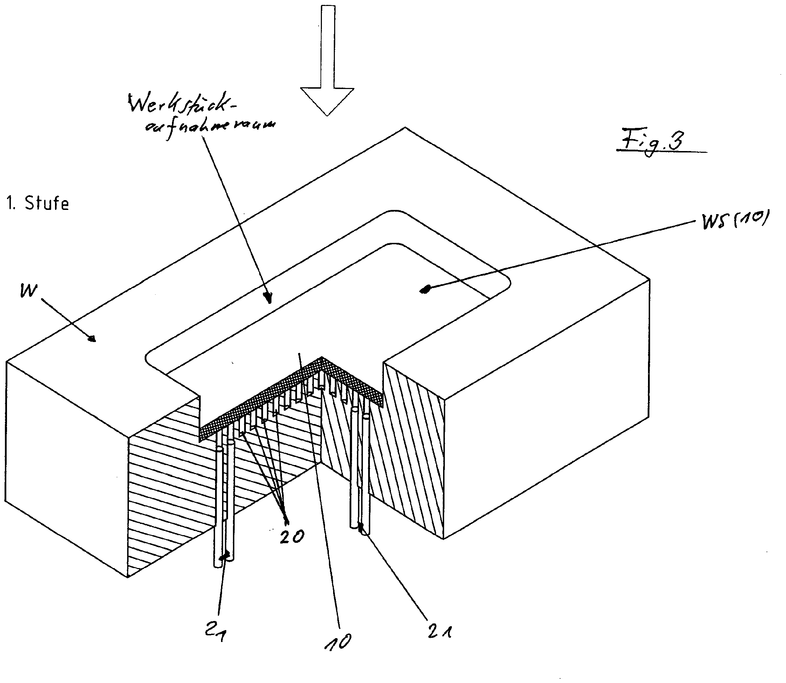

Wie aus Fig. 3 zu ersehen ist, ist das Werkstück WS oder der Flachmaterialzuschnitt 10 oder das Einlegeteil in das Werkzeug W auf dessen Boden aufliegend eingelegt und wird in dem Werkzeug W vollumfänglich umschlossen. Dies ist der Ausgangszustand für die Umformbearbeitung in der ersten Stufe.

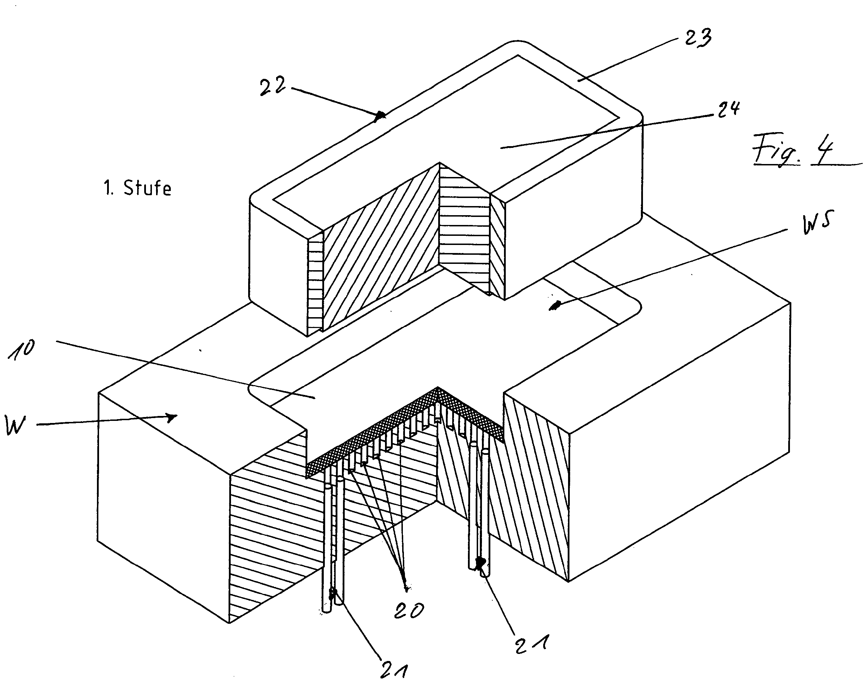

In Fig. 4 ist schematisch in Teilschnittdarstellung eine für die Umformbearbeitung in der ersten Stufe eingesetzte Stempelanordnung gezeigt, welche insgesamt mit 22 bezeichnet ist. Die Stempelanordnung 22 umfasst wenigstens einen Außenstempel bzw. Umfangsrandstempel 23 und einen Innenstempel bzw. Pinstempel 24.

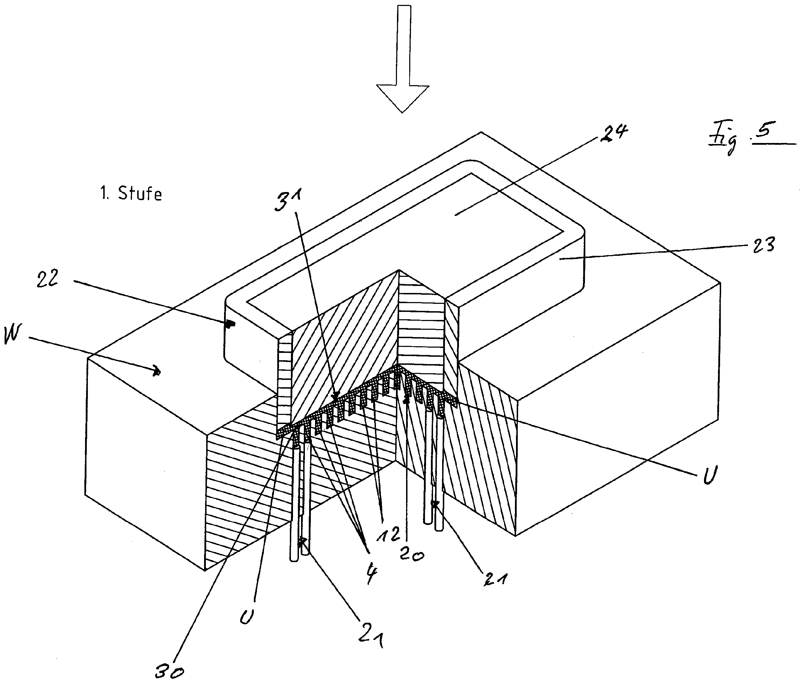

Die Stempelanordnung 22 wird wie gemäß Fig. 5 mit einem Pfeil angedeutet derart auf den Flachmaterialzuschnitt 10 bewegt, dass bei durch den Außenstempel 23 niedergehaltenem Werkstück WS bzw. 10 mittels des Innenstempels durch Pressen die Pins 4 im Zusammenwirken mit den Pinsausformöffnungen 20 in der ersten Stufe ausgeformt werden.

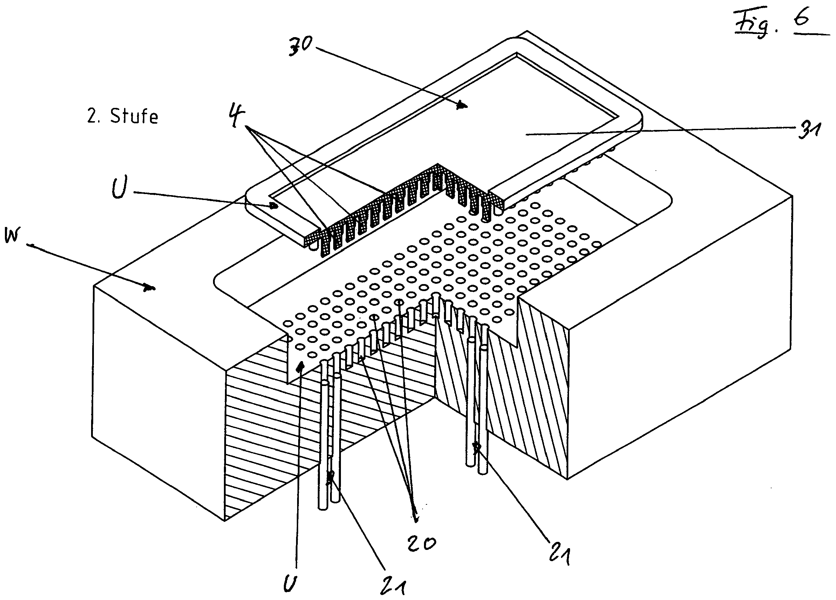

Aus Fig. 5 ist in Verbindung mit Fig. 6 ist zu ersehen, dass das am Ende der ersten Bearbeitungsstufe oder ersten Umformungsstufe erhaltene Bauteil 30 eine muldeförmige Vertiefung 31 im Bereich der mittels des Innenstempels 24 im Zusammenwirken mit den Ausformöffnungen 20 ausgebildeten Pins 4 aufweist.

Ausgehend von diesem am Ende der ersten Bearbeitungsstufe erhaltenen Bauteil 30 wird dieses in Fig. 6 für die Umformungbearbeitung in der zweiten Stufe derart im Werkzeug W angeordnet, dass die Pins 4 in die zugeordneten Pinausformöffnungen 20 ragen, und hierdurch das Bauteil 30 im Werkzeug W beim Einlegen zentriert wird.

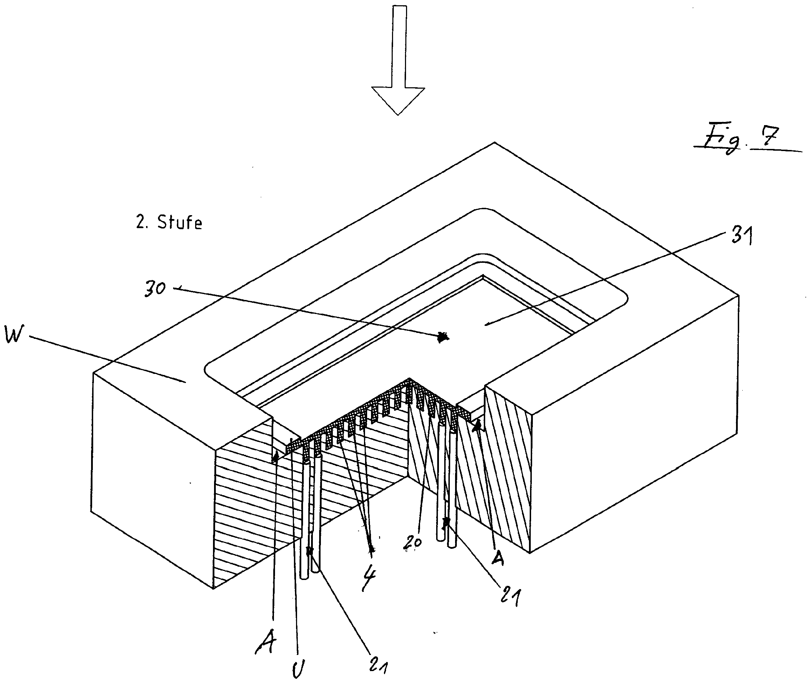

Aus Fig. 7 ist zu ersehen, dass das Bauteil 30 im Werkzeug W derart angeordnet ist, dass zwischen seitlichen Umfangsbegrenzungen des Werkzeugs W und dem Außenumfang des Bauteils 30 in Umfangsrichtung ein vorbestimmter Abstand A eingehalten wird.

Wie aus allen den Fig. 2 bis 10 der Zeichnung zu ersehen ist, verschließen in bevorzugter Weise Teile einer Auswurfeinrichtung 21 wenigstens einige der dem Umfangsrand U benachbarten Pinausformöffnungen 20. Hierdurch kann wirksam verhindert werden, dass bei der Pressbearbeitung zur Ausformung des Umfangsrandes U auch Material des Bauteils 30 in die Ausformöffnung 20 gelangt.

Die Fig. 6 bis 9 dienen zur Erläuterung der zweiten Bearbeitungsumformstufe.

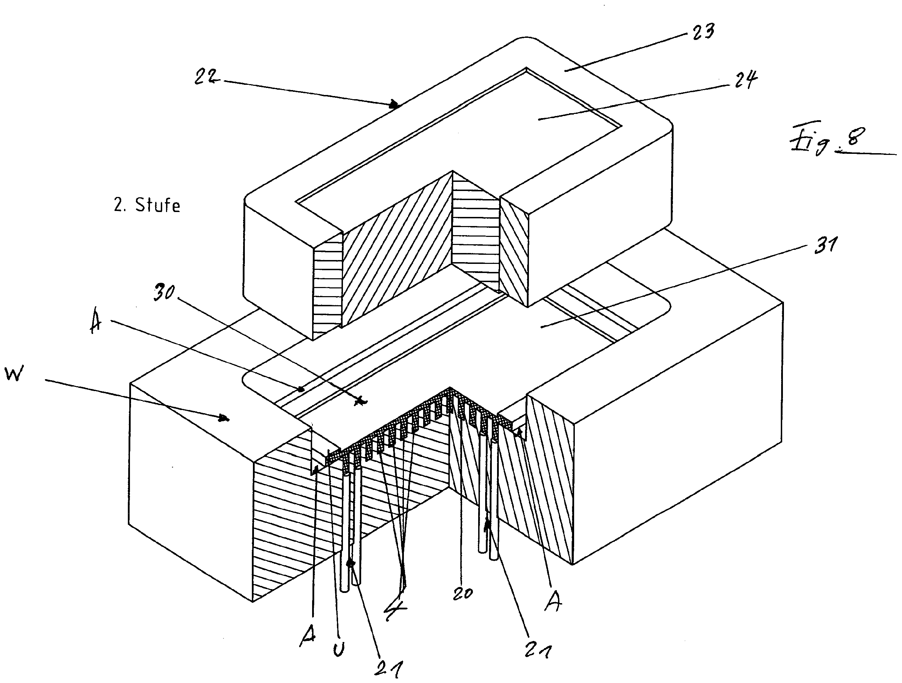

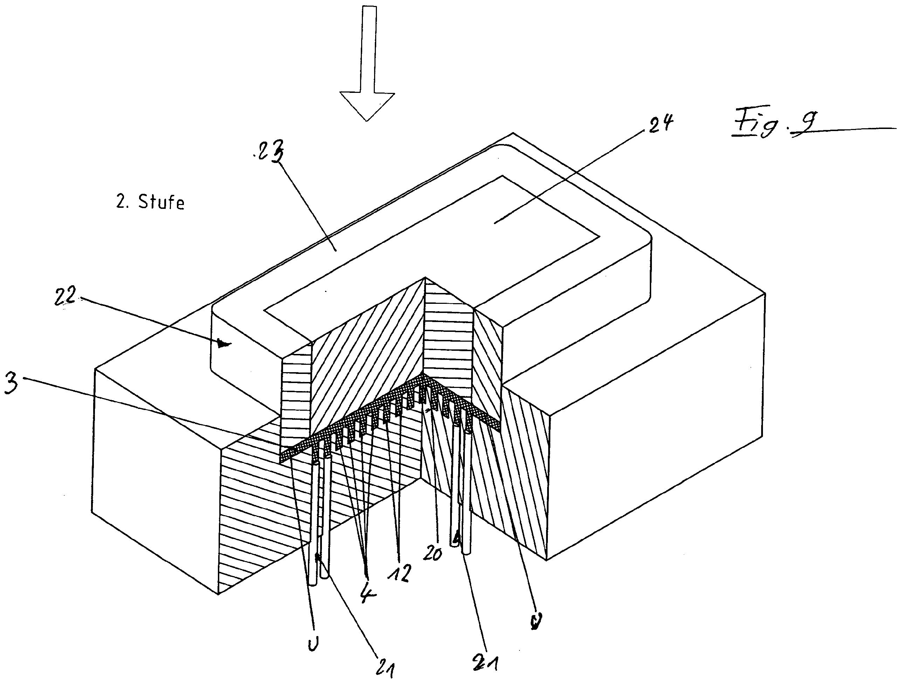

Wie aus Fig. 8 zu ersehen ist, umfasst die Stempelanordnung 22 wenigstens den Außenstempel bzw. Umfangsrandstempel 23 und den Innenstempel bzw. Pinstempel 24. Gemäß den Fig. 8 und 9 wird in der zweiten Stufe bei mittels des Innenstempels 24 niedergehaltenem Bauteil 30 mittels des Außenstempels bzw. Umfangsrandstempels 23 der Bereich des Umfangrandes U derart niedergepresst, dass der Bereich mit den ausgeformten Pins 4 bündig mit dem Umfangsrand abschließt oder in diesen übergeht. Somit erhält man einen im wesentlichen radial verlaufenden, ebenen Umfangsrand, der dann gegebenenfalls wirksam mit einer Dichtung zusammenarbeiten kann.

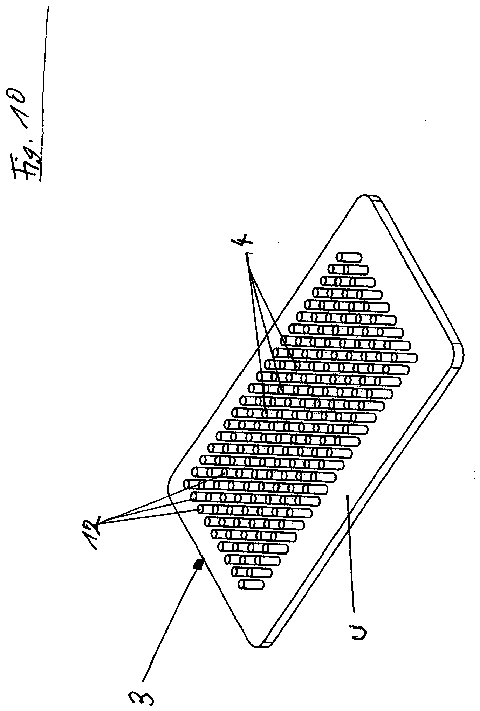

Nach der Bearbeitung in der zweiten Stufe erhält man dann eine Kühlplatte 3, welche in Fig. 10 schematisch in einer perspektivischen Ansicht gezeigt ist, und die sehr eng aneinanderliegende Pins 4 auf der Wirkfläche 5 hat. Der Umfangsrand U umgibt die Pins 4 und bildet eine gemeinsame Grundfläche mit dem Fußbereich der Pins 4.

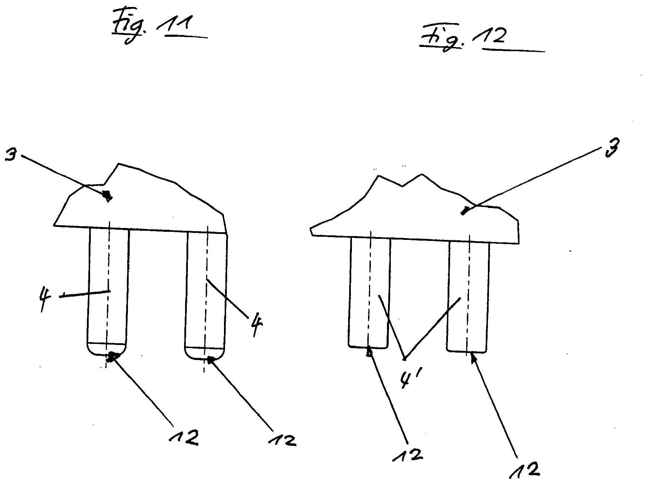

In Fig. 11 sind in schematischer, vergrößerter Darstellung zwei Pins gezeigt, deren Ausformung, wie in Fig. 2 bis Fig. 5 sowie Fig. 6 und Fig. 10 des Innenstempels 24 bei einem Pressvorgang im Zusammenwirken mit den Pinnausformöffnungen 20 gebildet werden. In Fig. 12 ist die Kühlplatte 3 nach einer Kalibrierung mit den Pins 4' verdeutlicht. Wie aus den Fig. 11 und 12 zu ersehen ist, haben die Pins 4. 4' nach der Ausformung bei der Umformung in der 1. Stufe nach Fig. 5 freien Enden 12, welche geringfügig nach außen gewölbt sind. Bei der Kalibrierung nach Fig. 12 sind diese freien Enden 12 eben gepresst worden, oder können auch aufgestaucht sei.

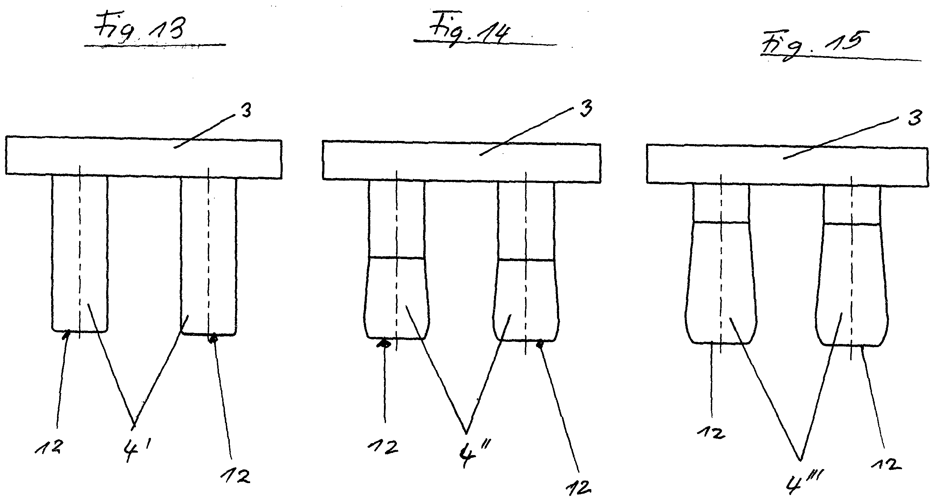

Anhand den Fig. 13 bis 15 schließlich werden schematisch weitere Ausführungsbeispiele von Ausgestaltungsformen der Pins 4 gezeigt.

Fig. 13 zeigt zylindrisch ausgebildete Pins 4'. In Fig. 14 ist als Beispiel eine gegenkonische Ausbildung von Pins 4" verdeutlicht, welche sich aber nur in etwa über die Hälfte der Höhe des jeweiligen Pins 4" erstreckt. Bei einer solchen gegenkonischen Ausbildung erfolgt ausgehend von den freien Enden der Pins 4" eine solche Kalibrierung, dass der Durchmesser der Pins 4" ausgehen vom freien Ende 12 in Richtung der Fußfläche kleiner wird.

Auch in Fig. 15 ist ein Beispiel einer solchen gegenkonischen Ausbildung von Pins 4" verdeutlicht. Hierbei reicht die gegenkonische Ausbildung bis nahezu zum Fußbereich der Pins 4". Alternativ können die Pins 4 insgesamt konisch oder teilkonisch ausgebildet werden. Dies wird mit Hilfe einer entsprechenden Kalibrierungsbehandlung erreicht. Bei einem solchen Fall erfolgt ausgehend von den freien Enden 12 der Pins 4 eine solche Kalibrierung, dass der Durchmesser der Pins 4 ausgehend vom freien Ende 12 in Richtung der Fußfläche größer wird.

Die Erfindung ist natürlich nicht auf die dargestellten Ausführungsbeispiele beschränkt, sondern es sind zahlreiche Abänderungen und Modifikationen möglich, die der Fachmann im Bedarfsfall treffen wird, ohne den Erfindungsgedanken zu verlassen. Insbesondere können die Pins 4, 4', 4" , 4"' in Abhängigkeit von dem jeweiligen Anwendungsbereich durch Kalibrierung auch von den dargestellten Ausführungsbeispielen abweichende Ausgestaltungsformen haben, oder auch Kombinationen der in den Figuren 11 bis 15 gezeigten Ausführungsbeispiele umfassen. Obgleich in den dargestellten Beispielen von einem rechteckförmigen Flachmaterialzuschnitt 10 ausgegangen wird, kann dieser natürlich auch allgemein viereckförmig oder oval oder dergleichen ausgebildet sein, und es kann sich auch um einen Flachmaterialzuschnitt von quadratischer Gestalt handeln.

Vorzugsweise kann der Flachmaterialzuschnitt von gewalztem oder gepresstem Material, insbesondere von gewalztem Kupfer, gebildet werden. Hierbei handelt es sich um ein Material mit sehr guter Wärmeleitfähigkeit

### Bezuqszeichenliste

- 1: Kühlanordnung insgesamt
- 2: zu kühlendes Bauteil
- 3: Kühlplatte
- 4: Pins in Fig. 11
- 4': Pins in Fig. 12 + 13
- 4": Pins in Fig. 14
- 4‴: Pins in Fig. 15
- 5: Wirkfläche
- 6: Dichtung
- 7: Deckel
- 8: Zwischenraum
- 9: Kühlmittel
- 10: Flachmaterialzuschnitt als Rohteil oder Werkstück WS
- 12: freies Ende von Pin 4
- 20: Pinausformöffnungen
- 21: Auswurfeinrichtung
- 22: Stempelanordnung insgesamt
- 23: Außenstempel
- 24: Innenstempel

- 30: in der ersten Stufe durch Umformen bearbeitetes Bauteil
- 31: muldenförmige Vertiefung im Bereich der Pins 4
- A: Abstand
- U: Umfangsrand
- W: Werkzeug
- WS: Werkstück

## Patentansprüche

1. Verfahren zur Herstellung einer Kühlplatte (3) aus Material mit sehr guter Wärmeleitfähigkeit, wie Kupfer, Aluminium oder deren Legierung mit etwa senkrecht über eine Grundfläche vorstehenden Pins (4, 4', 4", 4‴) auf einer vom Kühlmittel überstrichenen Wirkfläche (5), wobei die Pins (4, 4', 4", 4‴) von einem im wesentlichen radial verlaufenden, ebenen, funktionsnotwendigen Umfangsrand (U) umgeben sind, und die Kühlplatte (3) in einem Werkzeug (W) mittels Umformen eines Werkstücks (WS) hergestellt wird, wobei das Werkstück (WS) in Form eines Flachmaterialzuschnitts mit einheitlicher Materialdicke in das Werkzeug (W) eingelegt wird, welches wenigstens einen Außenstempel (23) zur Erzeugung des im wesentlichen ebenen Umfangsrandes und einen mit Pinausformöffnungen (20) im Werkzeug (W) zusammenarbeitenden Innenstempel (24)zur Erzeugung der Pins (4, 4', 4", 4‴) umfasst, **dadurch gekennzeichnet, dass** bei durch den Außenstempel (23) niedergehaltenem Werkstück (WS) in einer ersten Stufe mittels des Innenstempels (24) durch Pressen die Pins (4, 4', 4", 4‴) im Zusammenwirken mit den Pinausformöffnungen des Werkzeugs (W) ausgeformt werden, und dass in einer zweiten Stufe bei durch den Innenstempel (24) des Werkzeugs (W) niedergehaltenem Werkstück (WS) mit den ausgeformten Pins (4, 4', 4", 4‴) mittels des Außenstempels (23) durch Pressen der Umfangsrand (U) mit gegenüber der einheitlichen Materialdicke des in das Werkzeug (W) eingelegten Flachmaterialzuschnitts (WS) verminderter Materialdicke ausgeformt wird, so dass man einen im wesentlichen ebenen, funktionsnotwendigen Umfangsrand hierbei erhält, der im wesentlichen bündig in den Materialsenkenbereich nach der Ausformung der Pins übergeht.

2. Verfahren nach Anspruch 1, **dadurch gekennzeichnet, dass** die Pins (4, 4', 4", 4‴) ausgehend von ihren freien Enden kalibriert werden.

3. Verfahren nach Anspruch 2, **dadurch gekennzeichnet, dass** beim Kalibrieren die freien Enden der Pins (4, 4', 4", 4‴) eben gepresst oder aufgestaucht werden.

4. Verfahren nach Anspruch 2 oder 3, **dadurch gekennzeichnet, dass** ausgehend von den freien Enden der Pins (4, 4', 4", 4‴) eine solche Kalibrierung erfolgt, dass der Durchmesser der Pins ausgehend vom freien Ende in Richtung der Fußfläche kleiner wird, wobei eine gegenkonische Ausbildung erzeugt wird.

5. Verfahren nach Anspruch 2 oder 3, **dadurch gekennzeichnet, dass** ausgehend von den freien Enden der Pins (4, 4', 4", 4‴) eine solche Kalibrierung erfolgt, dass der Durchmesser der Pins ausgehend vom freien Ende in Richtung der Fußfläche größer wird, wobei eine konische Ausbildung erzeugt wird.

6. Verfahren nach einem der vorangehenden Ansprüche, **dadurch gekennzeichnet, dass** der Flachmaterialzuschnitt viereckförmig ausgebildet ist.

7. Verfahren nach Anspruch 6, **dadurch gekennzeichnet, dass** der Flachmaterialzuschnitt rechteckförmig ausgebildet ist.

8. Verfahren nach einem der vorangehenden Ansprüche, **dadurch gekennzeichnet, dass** der Flachmaterialzuschnitt von gewalztem oder gepresstem Material, vorzugsweise von gewalztem Kupfer, gebildet wird.

## Claims

1. A method for producing a cooling plate (3) from a material with very good thermal conductivity, such as copper, aluminium, or an alloy thereof, with pins (4, 4', 4", 4"') protruding approximately perpendicular over a base area on an effective surface (5) swept by coolant, wherein the pins (4, 4', 4", 4"') are surrounded by a substantially radially extending, flat peripheral edge (U) which is functionally necessary, and the cooling plate (3) is produced in a tool (W) by means of deformation of a workpiece (WS), wherein the workpiece (WS) is inserted in the tool (W) in the form of a flat material blank with uniform material thickness, which tool comprises at least one outer punch (23) for producing the substantially flat peripheral edge and an inner punch (24) cooperating with pin forming openings (20) in the tool (W) to produce the pins (4, 4', 4", 4"'), **characterised in that,** in a first stage, by means of the inner punch (24), the pins (4, 4', 4", 4"') are deformed in collaboration with the pin forming openings of the tool (W) by pressing, in the workpiece (WS) held down by the outer punch (23), and that, in a second stage, by means of the outer punch (23), the peripheral edge (U) is moulded with a material thickness which Is reduced vis-à-vis the uniform material thickness of the flat material blank (WS) inserted into the tool (W), by pressing, in the workpiece (WS) held down by the inner punch (24) of the tool (W), with the formed pins (4, 4', 4", 4"'), with the result that a substantially flat, functionally necessary peripheral edge is obtained, which edge transitions, substantially flush, into the material depression region after the pins are formed.

2. The method according to claim 1, **characterised in that** the pins (4, 4', 4", 4‴) are calibrated, starting from their free ends.

3. The method according to claim 2, **characterised in that,** during calibration, the free ends of the pins (4, 4', 4", 4‴) are pressed flat or upset.

4. The method according to claim 2 or 3, **characterised in that,** starting from the free ends of the pins (4, 4', 4", 4‴), calibration takes place such that the diameter of the pins decreases in the direction of the foot area, wherein a counter-conical design is produced.

5. The method according to claim 2 or 3, **characterised in that,** starting from the free ends of the pins (4, 4', 4", 4"'), calibration takes place such that the diameter of the pins increases in the direction of the foot area, wherein a conical design is produced.

6. The method according to one of the preceding claims, **characterised in that** the flat material blank is designed to be quadrangular.

7. The method according to claim 6, **characterised in that** the flat material blank is designed to be rectangular.

8. The method according to one of the preceding claims, **characterised in that** the flat material blank is formed from rolled or pressed material, preferably from rolled copper.

## Revendications

1. Procédé de fabrication d'une plaque de refroidissement (3) en un matériau présentant une conductivité thermique très satisfaisante, tel que le cuivre, l'aluminium ou leurs alliages avec des broches (4, 4', 4", 4‴) faisant saillie à peu près de manière perpendiculaire hors d'une surface de base sur une surface active (5) recouverte par le moyen de refroidissement, les broches (4, 4', 4", 4‴) étant entourées par un bord périphérique plat (U) nécessaire au fonctionnement, s'étendant sensiblement de manière radiale et la plaque de refroidissement (3) étant fabriquée dans un outil (W) au moyen d'un façonnage d'une pièce (WS), la pièce (WS) étant insérée dans l'outil (W) sous la forme d'une découpe de matériau plat présentant une épaisseur de matériau homogène, l'outil (W) comprenant au moins un poinçon extérieur (23) pour générer le bord périphérique sensiblement plat et un poinçon intérieur (24) coopérant avec les ouvertures de formage de broches dans l'outil (W) pour générer les broches (4, 4', 4", 4‴), **caractérisé en ce que** les broches (4, 4', 4", 4‴) sont formées par pressage au moyen du poinçon intérieur (24) lors d'une première étape, à pièce (WS) maintenue en position basse par le poinçon extérieur (23) lors de la coopération avec les ouvertures de formage de broches de l'outil (W) et que lors d'une deuxième étape, à pièce (WS) maintenue en position basse avec les broches (4, 4', 4", 4‴) formées par le poinçon intérieur (24) de l'outil (W), le bord périphérique (U) est formé par pressage au moyen du poinçon extérieur (24) avec une épaisseur de matériau réduite par rapport à l'épaisseur de matériau homogène de la découpe de matériau plat (WS) insérée dans l'outil (W), de sorte à obtenir un bord périphérique sensiblement plat nécessaire au fonctionnement, qui se prolonge sensiblement à fleur dans la zone de matériau creuse après la formation des broches.

2. Procédé suivant la revendication 1, **caractérisé en ce que** les broches (4, 4', 4", 4‴) sont calibrées à partir de leurs extrémités libres.

3. Procédé suivant la revendication 2, **caractérisé en ce que** les extrémités libres des broches (4, 4', 4", 4‴) sont pressées à plat ou refoulées.

4. Procédé suivant la revendication 2 ou 3, **caractérisé en ce qu'**à partir des extrémités libres des broches (4, 4', 4", 4"') a lieu un calibrage de telle sorte que le diamètre des broches diminue à partir de l'extrémité libre dans la direction de l'embase, ce qui génère une formation conique inverse.

5. Procédé suivant la revendication 2 ou 3, **caractérisé en ce qu'**à partir des extrémités libres des broches (4, 4', 4", 4"') a lieu un calibrage de telle sorte que le diamètre des broches s'accroît à partir de l'extrémité libre en direction de l'embase, ce qui génère une formation conique.

6. Procédé suivant une des revendications précédente, **caractérisé en ce que** la découpe de matériau plat est quadrangulaire.

7. Procédé suivant la revendication 6, **caractérisé en ce que** la découpe de matériau plat est de forme rectangulaire.

8. Procédé suivant une des revendications précédentes, **caractérisé en ce que** la découpe de matériau plat est formée par un matériau laminé ou pressé, de préférence par du cuivre laminé.
